# EUROPEAN PATENT APPLICATION

(11) **EP 4 516 742 A1**
(43) Date of publication of application: **05.03.2025**
(21) Application number: 22961640.4
(22) Date of filing: 10.10.2022
(51) Int. Cl.: C01G 21/16, B09B 3/70

(54) **METHOD AND SYSTEM FOR RECOVERING LEAD IODIDE FROM PEROVSKITE SOLAR CELL**

(71) Applicant: Contemporary Amperex Technology (Hong Kong) Limited, Hong Kong (HK)
(72) Inventor: LIANG, Weifeng, Ningde, Fujian 352100 (CN); CHEN, Changsong, Ningde, Fujian 352100 (CN); GUO, Wenming, Ningde, Fujian 352100 (CN); SU, Shuojian, Ningde, Fujian 352100 (CN); TU, Bao, Ningde, Fujian 352100 (CN); XIANG, Ling, Ningde, Fujian 352100 (CN); LUAN, Bo, Ningde, Fujian 352100 (CN); CAO, Yunxuan, Ningde, Fujian 352100 (CN); GUO, Yongsheng, Ningde, Fujian 352100 (CN); CHEN, Guodong, Ningde, Fujian 352100 (CN)
(74) Representative: Gong, Jinping
(86) International application number: PCT/CN2022/124398
(87) International publication number: WO 2024/077444

(57) **Abstract**

This application discloses a method for recovering lead iodide from a perovskite solar battery, and a recycling system. The method for recovering lead iodide from a perovskite solar battery includes the following steps: pretreating a recycled perovskite solar battery to obtain perovskite; putting the perovskite into a second solvent to dissolve lead iodide to obtain a lead iodide-containing solution; and mixing the lead iodide-containing solution with a third solvent to precipitate the lead iodide, and collecting a lead iodide precipitate. A boiling point of the third solvent is lower than a boiling point of the second solvent. The recycling system for recovering lead iodide from a perovskite solar battery includes: a recycled perovskite solar battery stripping apparatus, a lead iodide extraction apparatus, and a lead iodide precipitate separation apparatus. The method and recycling system for recovering lead iodide from a perovskite solar battery in an embodiment of this application improve the purity and recovery rate of the lead iodide precipitate with low energy consumption.

## Description

### TECHNICAL FIELD

This application relates to the technical field of solar batteries, and in particular, to a method and recycling system for recovering lead iodide from a perovskite solar battery.

### BACKGROUND

A perovskite solar battery is a third-generation new solar battery that uses an organic-inorganic hybrid metal halide semiconductor as a light-absorbing layer. With the iteration of technology, the current certified photoelectric conversion efficiency of a single-cell perovskite solar battery has exceeded 25.7%, which is comparable to crystalline-silicon solar cells. By virtue of high stability of the perovskite solar batteries additionally, the application field of the perovskite solar batteries is expanding progressively.

Currently, components of a perovskite solar battery typically include a transparent conductive glass electrode, a charge transport material (hole and electron transport materials), a perovskite light-absorbing layer, and a counter electrode. Among the components, the perovskite light-absorbing layer contains a large amount of lead ions highly toxic to the environment and the human body. Although some improvements have been made to the perovskite solar batteries to effectively prevent the problem of lead leakage during use, a large number of used perovskite solar batteries have been accumulated with the advancement of the industrialization of the perovskite solar batteries, thereby inevitably posing a challenge of recycling the perovskite solar batteries. If left untreated, the used perovskite solar batteries will cause severe damage to the environment.

Although there are some public reports on the recovery of lead iodide from perovskite solar batteries, the currently disclosed recovery of lead iodide suffers from low purity and high energy consumption, and is unfavorable to industrial processing.

### SUMMARY

In view of the above problems, some embodiments of this application provide a method and a recycling system for recovering lead iodide from a perovskite solar battery, so as to solve the technical problems of a low purity, high energy consumption, and being unfavorable to industrial processing in an existing method for recovering lead iodide from a perovskite solar battery.

According to a first aspect, an embodiment of this application provides a method for recovering lead iodide from a perovskite solar battery. The method includes the following steps:
pretreating a recycled perovskite solar battery to obtain perovskite;
putting the perovskite into a second solvent to dissolve lead iodide to obtain a lead iodide-containing solution; and
mixing the lead iodide-containing solution with a third solvent to precipitate the lead iodide, and collecting a lead iodide precipitate, where a boiling point of the third solvent is lower than a boiling point of the second solvent.

In the technical solution of this embodiment of this application, the lead iodide in the recycled perovskite is dissolved, and then the lead iodide is directly precipitated from the lead iodide-containing solution by a precipitation method by using a relatively low-boiling solvent as a counter-solvent, so as to separate the lead iodide from the second solvent. This significantly reduces or avoids residues of the second solvent or the like in the lead iodide, and effectively improves the purity of the lead iodide. In addition, the method achieves a high recovery rate of the lead iodide, and avoids high-temperature distillation, thereby reducing energy consumption and simplifying the recovery process, and being applicable to industrialized recovery. Moreover, the boiling point of the third solvent is lower than that of second solvent. Therefore, the third solvent and the second solvent can be collected separately from a mixed filtrate of the third solvent and the second solvent by a low-temperature separation process after the lead iodide is separated and precipitated, thereby reducing the emission of waste liquid, improving the environment-friendliness, and reducing the economic cost.

In some embodiments, the second solvent includes a complexing solvent. The complexing solvent, which can be complexed with the lead iodide to form a complex, is selected as the second solvent configured to dissolve the lead iodide, thereby effectively increasing the dissociation rate of lead iodide from the perovskite, and improving the recovery rate of lead iodide.

In a further embodiment, the complexing solvent includes dimethyl sulfoxide or a mixed solvent formed by mixing dimethyl sulfoxide with at least one of N,N-dimethylformamide, N-methyl-pyrrolidone, or γ-butyrolactone. These complexing solvents can increase the complexed amount of lead iodide, the stability and amount of dissolved lead iodide, and the recovery rate of the lead iodide.

In some embodiments, the perovskite includes a plurality of sheets, and the plurality of sheets of perovskite are placed together in the second solvent to dissolve the lead iodide. Placing a plurality of sheets of perovskite together to dissolve lead iodide can effectively improve the efficiency of the lead iodide dissolution, save the amount of the second solvent used, and improve the extraction efficiency of the lead iodide.

The step of dissolving the lead iodide is accompanied by ultrasonication. The ultrasonication improves the efficiency of the lead iodide dissolution, and improves the dissolution rate of the lead iodide.

In some embodiments, the third solvent includes at least one of alcohol, ketone, ether, ester, or aromatic hydrocarbon. These solvents boil at a low boiling point, and can effectively induce precipitation and separation of lead iodide from the second solvent, and are easily separated and collected from the second solvent at a low temperature.

In a further embodiment, the alcohol includes at least one of ethanol, methanol, propanol, or butanol; the ketone includes at least one of acetone or butanone; the ether includes at least one of methyl ether, methyl ethyl ether, ethyl ether, or petroleum ether; the ester includes at least one of methyl formate, ethyl formate, methyl acetate, or ethyl acetate; and the aromatic hydrocarbon includes at least one of hexane, pentane, or heptane. These types of alcohols, ketones, ethers, esters, aromatic hydrocarbons, and the like used as solvents boil at a low boiling point, and are highly effective in precipitating and separating the lead iodide and in recovering and collecting the lead iodide at a low temperature.

In some embodiments, steps of pretreating a recycled perovskite solar battery include:
removing a glass layer and an electrode layer from the perovskite solar battery to obtain a solar battery that exposes a transport layer; and
putting the solar battery with the exposed transport layer into a transport layer dissolvent to dissolve the transport layer, and then cleaning the solar battery by using a first solvent, and drying the cleaned product to obtain perovskite, where a boiling point of the first solvent is lower than the boiling point of the second solvent.

The pretreatment process containing such steps can effectively improve the efficiency of the pretreatment, play a role in preliminarily purifying the perovskite, and improve the recovery rate and purity of the lead iodide.

In a further embodiment, the step of cleaning by using a first solvent is accompanied by ultrasonication. By means of the ultrasonication, the cleaning effect is improved, and at least some A-site components of the perovskite can be dissolved in the first solvent, thereby improving the efficiency of the subsequent purification of the lead iodide.

In a further embodiment, the transport layer dissolvent includes at least one of chlorobenzene, methylbenzene, dichlorobenzene, ethyl acetate, or dimethylbenzene. These transport layer dissolvents can effectively dissolve the transport layer included in the perovskite solar battery, and separate the transport layer from the perovskite layer.

In some embodiments, after the step of collecting a lead iodide precipitate, the method further includes a step of purifying the collected lead iodide precipitate: washing the lead iodide precipitate for at least one time by using a fourth solvent, where a boiling point of the fourth solvent is lower than the boiling point of the second solvent.

Purification of the lead iodide precipitate can further effectively reduce the content of impurities and further improve the purity of the lead iodide.

In a further embodiment, the first solvent and the fourth solvent each independently include at least one of alcohol, ketone, ether, ester, or aromatic hydrocarbon. These types of first solvents can effectively improve the capabilities of dissolving the residual transport layer dissolvent and dissolving some A-site constituents in the perovskite, and can be easily dried at a low temperature. These types of fourth solvents can effectively dissolve the impurities that remain in the lead iodide precipitate and purify the lead iodide precipitate, and are of a low boiling point and easily separable from the lead iodide precipitate without leaving residue.

In a still further embodiment, the alcohol includes at least one of ethanol, methanol, propanol, or butanol; the ketone includes at least one of acetone or butanone; the ether includes at least one of methyl ether, methyl ethyl ether, ethyl ether, or petroleum ether; the ester includes at least one of methyl formate, ethyl formate, methyl acetate, or ethyl acetate; and the aromatic hydrocarbon includes at least one of hexane, pentane, or heptane. The types of alcohols, ketones, ethers, esters, aromatic hydrocarbons, and the like used as solvents boil at a low boiling point, and are highly effective in dissolving impurities, and can be effectively removed at a low temperature without leaving residue.

In a specific embodiment, the first solvent, the third solvent, and the fourth solvent each independently are at least one of ethanol, methanol, propanol, or butanol. The second solvent is dimethyl sulfoxide. By controlling the first solvent, the third solvent, and the fourth solvent each independently to be the low-boiling alcohol solvents, the impurities can be effectively removed from the lead iodide during recycling, thereby improving the purity of the lead iodide. Moreover, the solvents are easily recyclable. At the same time, the dimethyl sulfoxide is selected as the second solvent, so that dimethyl sulfoxide and such alcohols play a role in enhancing the efficiency, thereby improving the recovery rate of the lead iodide in addition to the purity of the lead iodide.

In a further embodiment, when collecting the lead iodide precipitate, the method further includes the following recycling step for a mixed filtrate containing the second solvent and the third solvent:
fractionating the mixed filtrate to obtain a recovered second solvent and a recovered third solvent separately; and
introducing the recovered second solvent into the process of lead iodide dissolution, and introducing the recovered third solvent into the process of mixing the lead iodide-containing solution with the third solvent.

By fractionating the mixed filtrate, the second solvent and the third solvent can be separated and recycled, thereby effectively reducing the amount of the second solvent and third solvent used, effectively saving the solvents, reducing the economic cost, reducing the emission of waste liquid during the recovery of the lead iodide, and improving the environment-friendliness.

In some embodiments, the lead iodide at least exhibits any one of the following characteristics:
a crystallographic orientation of the lead iodide is (0 0 1);
a purity of the lead iodide is 99.1 mol% or higher;
a thermal weight loss of the lead iodide is less than 0.7 wt%; or
a solubility of the lead iodide in a DMF solvent is 0.5 g/ml.

The lead iodide recovered by the method for recovering lead iodide from a perovskite solar battery in an embodiment of this application exhibits a low crystallographic orientation, a high purity, and a high solubility.

According to a second aspect, an embodiment of this application provides a recycling system for recovering lead iodide from a perovskite solar battery. The recycling system for recovering lead iodide from a perovskite solar battery in an embodiment of this application is configured to implement the method for recovering lead iodide from a perovskite solar battery in an embodiment of this application. The recycling system includes:
a recycled perovskite solar battery stripping apparatus, configured to strip the recycled perovskite solar battery to recover perovskite;
a lead iodide extraction apparatus, configured to extract lead iodide from the perovskite; and
a lead iodide precipitate separation apparatus, configured to perform precipitation on the lead iodide-containing solution obtained through treatment by the lead iodide extraction apparatus, so as to obtain the lead iodide precipitate.

In the technical solution of this embodiment of this application, the recycling system for recovering lead iodide from a perovskite solar battery implements separation of the perovskite and preliminary collection of the lead iodide through the synergistic operations of the recycled perovskite solar battery stripping apparatus and the lead iodide extraction apparatus included in the system. On this basis, the lead iodide precipitate separation apparatus can collect and separate lead iodide by a solvent precipitation method, thereby effectively improving the purity of the recovered lead iodide and the recovery rate, reducing the emission of waste liquid, improving the environmental friendliness of the lead iodide recovery, and reducing the economic cost.

In some embodiments, the recycled perovskite solar battery stripping apparatus includes a glass substrate stripping apparatus, an electrode separation apparatus, a transport layer dissolution apparatus, and a perovskite cleaning apparatus. The glass substrate stripping apparatus, the electrode separation apparatus, the transport layer dissolution apparatus, and the perovskite cleaning apparatus are connected sequentially in such order that the recycled perovskite solar battery undergoes the following processes sequentially: glass substrate stripping, electrode separation, transport layer dissolution, and perovskite cleaning. The perovskite cleaning apparatus is connected to the lead iodide extraction apparatus. The glass substrate stripping apparatus, the electrode separation apparatus, the transport layer dissolution apparatus, and the perovskite cleaning apparatus are connected sequentially in the order of the pretreatment sequence of the recycled perovskite solar battery. In this way, the recycled perovskite solar battery undergoes the glass substrate stripping, electrode separation, transport layer dissolution, and perovskite cleaning sequentially, thereby preliminarily purifying the perovskite, improving the recovery rate of the lead iodide, and improving the pretreatment efficiency.

In some embodiments, the lead iodide extraction apparatus includes at least a lead iodide dissolution vessel and a first solid-liquid separation component; and, in the lead iodide extraction apparatus, the lead iodide dissolution vessel and the first solid-liquid separation component are connected sequentially in such order that the lead iodide dissolution occurs before the solid-liquid separation.

The lead iodide precipitate separation apparatus includes at least a lead iodide precipitation vessel and a second solid-liquid separation component; and, in the lead iodide precipitate separation apparatus, the lead iodide precipitation vessel and the second solid-liquid separation component are connected sequentially in such order that the lead iodide precipitation occurs before the solid-liquid separation, where the lead iodide precipitation vessel is connected to a solution outlet of the first solid-liquid separation component.

The lead iodide extraction apparatus can efficiently extract lead iodide from the perovskite, and remove insoluble impurities. The lead iodide precipitate washing apparatus can clean and purify the lead iodide precipitate obtained from the lead iodide precipitate separation apparatus, thereby further improving the purity of the lead iodide.

In a further embodiment, the lead iodide precipitate separation apparatus further includes a fractionation component. The fractionation component is connected to a solution outlet of the second solid-liquid separation component. The fractionation component includes at least a second solvent outlet and a third solvent outlet. The second solvent outlet is connected to the lead iodide dissolution vessel. The third solvent outlet is connected to the lead iodide precipitation vessel. By disposing the fractionation component and controlling the connection of the fractionation component to other components, the recycling system can effectively recover the second solvent and the third solvent, and implement the recycling and reuse of the second solvent and the third solvent, thereby effectively reducing the cost of recovering the lead iodide in the recycling system that recovers the lead iodide from a perovskite solar battery, reducing the emission of waste liquid, and improving environmental friendliness.

In some embodiments, the system further includes a lead iodide purification apparatus. The lead iodide purification apparatus is connected to the lead iodide precipitate separation apparatus. The lead iodide purification apparatus can further effectively reduce the purity of the lead iodide.

The foregoing description is merely an overview of the technical solutions of this application. Some specific embodiments of this application are described below illustratively to enable a clearer understanding of the technical solutions of this application, enable implementation of the technical solutions based on the subject-matter hereof, and make the foregoing and other objectives, features, and advantages of this application more evident and comprehensible.

### BRIEF DESCRIPTION OF DRAWINGS

By reading the following detailed description of exemplary embodiments, a person of ordinary skill in the art becomes clearly aware of various other advantages and benefits. The drawings are merely intended to illustrate the exemplary embodiments, but not to limit this application. In all the drawings, the same reference numeral represents the same component. In the drawings:
FIG. 1 is a schematic structural diagram of a perovskite solar battery according to an embodiment of this application;
FIG. 2 is a schematic flowchart of a method for recovering lead iodide from a perovskite solar battery according to an embodiment of this application;
FIG. 3 is a schematic flowchart of a method for recovering lead iodide from a perovskite solar battery including a purification step according to an embodiment of this application;
FIG. 4 is an exemplary schematic flowchart of a method for recovering lead iodide from a perovskite solar battery according to an embodiment of this application; and
FIG. 5 shows a recycling system for recovering lead iodide from a perovskite solar battery according to an embodiment of this application.

### List of reference numerals:

01. recycled perovskite solar battery stripping apparatus; 11. glass substrate stripping apparatus; 12. electrode separation apparatus; 13. transport layer dissolution apparatus; 14. perovskite cleaning apparatus;
131. transport layer dissolution vessel;
141. cleaning component; 142. drying component;
02. lead iodide extraction apparatus. 21. lead iodide dissolution vessel; 22. first solid-liquid separation component;
03. lead iodide precipitate separation apparatus; 31. lead iodide precipitation vessel; 32. second solid-liquid separation component; 33. fractionation component; 331. second solvent outlet; 332 third solvent outlet;
04. lead iodide purification apparatus; 41. lead iodide washing component; 42. vacuum-drying component.

### DETAILED DESCRIPTION OF EMBODIMENTS

Some embodiments of the technical solutions of this application are described in detail below with reference to the drawings. The following embodiments are merely intended as examples to describe the technical solutions of this application more clearly, but not intended to limit the protection scope of this application.

Unless otherwise defined, all technical and scientific terms used herein bear the same meanings as what is normally understood by a person skilled in the technical field of this application. The terms used herein are merely intended to describe specific embodiments but not to limit this application. The terms "include" and "contain" and any variations thereof used in the specification, claims, and brief description of drawings of this application are intended as non-exclusive inclusion.

In the description of some embodiments of this application, the technical terms "first" and "second" are merely intended to distinguish between different items but not intended to indicate or imply relative importance or implicitly specify the number of the indicated technical features, specific order, or order of precedence. In the description of some embodiments of this application, unless otherwise expressly specified, "a plurality of" means two or more.

Reference to an "embodiment" herein means that a specific feature, structure or characteristic described with reference to this embodiment may be included in at least one embodiment of this application. Reference to this term in different places in the specification does not necessarily represent the same embodiment, nor does it represent an independent or alternative embodiment in a mutually exclusive relationship with other embodiments. A person skilled in the art explicitly and implicitly understands that the embodiments described herein may be combined with other embodiments.

In the description of embodiments of this application, the term "and/or" merely indicates a relationship between related items, and represents three possible relationships. For example, "A and/or B" may represent the following three circumstances: A alone, both A and B, and B alone. In addition, the character "/" herein generally indicates an "or" relationship between the item preceding the character and the item following the character.

In the description of embodiments of this application, the term "a plurality of" means two or more (including two). Similarly, "a plurality of groups" means two or more groups (including two groups), and "a plurality of pieces" means two or more pieces (including two pieces).

In the description of embodiments of this application, a direction or a positional relationship indicated by the terms such as "center", "longitudinal", "transverse", "length", "width", "thickness", "up", "down", "before", "after", "left", "right", "vertical", "horizontal", "top", "bottom", "in", "out", "clockwise", "counterclockwise", "axial", "radial", and "circumferential" is a direction or positional relationship based on the illustration in the drawings, and is merely intended for ease or brevity of description of embodiments of this application, but not intended to indicate or imply that the indicated device or component is necessarily located in the specified direction or constructed or operated in the specified direction. Therefore, such terms are not to be understood as a limitation on embodiments of this application.

In the description of this application, unless otherwise expressly specified and defined, the technical terms such as "mount", "concatenate", "connect", and "fix" are generic in a broad sense, for example, mean a fixed connection, a detachable connection, or a one-piece configuration; or mean a mechanical connection or an electrical connection; or mean a direct connection or an indirect connection implemented through an intermediary; or mean internal communication between two components or interaction between two components. A person of ordinary skill in the art can understand the specific meanings of the terms in some embodiments of this application according to specific situations.

Due to a much higher light-absorptivity than crystalline silicon, the perovskite material incurs a low loss during energy conversion, and can still implement high energy conversion even in indoor or low-light conditions. As a result, the conversion efficiency of perovskite solar batteries has increased rapidly in the past decade. Therefore, the application field of the perovskite solar batteries is expanding progressively. The perovskite solar batteries have been mass-produced by some enterprises by now.

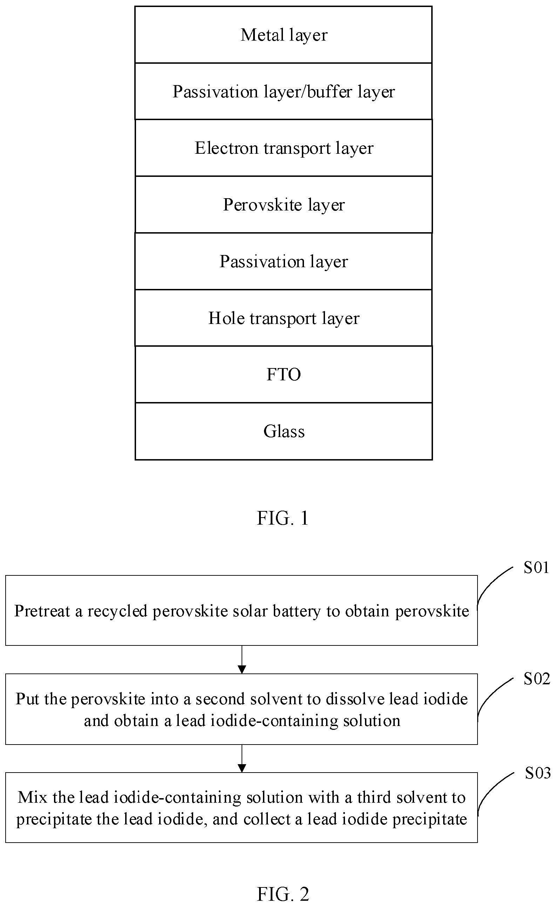

The structure of a perovskite solar battery typically includes a transparent conductive glass electrode, a charge transport material (hole and electron transport materials), a perovskite light-absorbing layer, and a counter electrode. Specifically, the perovskite solar battery may assume a structure shown in FIG. 1. The general formula of the halide perovskite contained in the perovskite light-absorbing layer is ABX₃, where A is generally an organic amine ion or cesium ion, such as CH₃NH₃⁺ (MA⁺), CH₃NH₃⁺ (FA⁺), or Cs⁺; B is a divalent metal ion, such as Pb²⁺, Ge²⁺, Sn²⁺, typically Pb²⁺; and X is a halogen ion, such as I¹⁺, Br¹⁺, Cl¹⁺, typically Pb²⁺. These three types of ions form a cubic arrangement while the metal ions and halogen ions need to form an octahedron so as to form a three-dimensional framework.

Therefore, the perovskite solar battery contains heavy metals, and typically contains lead iodide (PbI₂). The advancement of the industrialization of the perovskite solar batteries inevitably poses challenges of perovskite solar battery recycling and environmental pollution. Therefore, recycling the perovskite solar batteries is a necessary and important process in the production and application of the perovskite solar batteries.

With respect to the recovery of lead iodide contained in a perovskite solar battery, a currently disclosed method for recovering lead iodide generally includes: disassembling a perovskite solar battery to obtain a perovskite light-absorbing layer; soaking the perovskite light-absorbing layer in a high-boiling solvent to extract lead iodide; and then distilling the lead iodide-containing solution to collect lead iodide crystals. A currently disclosed lead iodide recovery process based on a perovskite precursor waste solution is: performing precipitation first, and then soaking the perovskite light-absorbing layer in a high-boiling solvent to extract lead iodide, and then distilling the lead iodide-containing solution to collect lead iodide crystals.

Through research, the inventor finds that although the currently disclosed lead iodide recovery methods can dissolve out the lead iodide constituents from a perovskite layer structure by using a high-boiling solvent, the perovskite layer contains not only lead iodide, but also other elements such as the foregoing A-site elemental constituents due to the characteristics and elements of the perovskite material contained in the perovskite layer. Therefore, in dissolving the lead iodide by using a high-boiling solvent, the A-site constituents are usually at least partially dissolved together in the high-boiling solvent. As a result, the accompanying impurities are unable to be separated from the lead iodide in the distillation and crystallization stage, thereby resulting in a low purity of the recovered lead iodide. Moreover, in the distillation stage, due to the high boiling point of the high-boiling solvent, the solvent is unable to be completely evaporated effectively by distilling. Consequently, residues exist in the recovered lead iodide, thereby further leading to a low purity of the recovered lead iodide. The distillation of a high-boiling solvent is highly energy-consuming. Furthermore, the high-temperature distillation leads to low stability of lead iodide recovery, and the difficulty of controlling the recovery process is increased. Consequently, in the recovery of lead iodide, especially in the industrialized recovery, the purity of the lead iodide is overly low, the stability of the lead iodide recovery is low, the cost is increased significantly, thereby being unfavorable to the industrialized recovery.

In view of the above disadvantages of lead iodide recovery in the industry currently, after in-depth research, the inventor discloses a method for recovering lead iodide from a perovskite solar battery. In the method for recovering lead iodide from a perovskite solar battery in an embodiment of this application, the perovskite solar battery to be recycled is pretreated first, so as to strip off other components of the recovered perovskite solar battery to obtain a perovskite function layer. Subsequently, the lead iodide is dissolved out from the perovskite in the perovskite function layer by using a second solvent capable of dissolving the lead iodide, so as to separate the lead iodide from the perovskite. Next, the lead iodide is precipitated from a lead iodide-containing solution by using a counter-solvent, so that the lead iodide is recovered by a precipitation method. In this way, the lead iodide is separated by a precipitation method, thereby effectively avoiding the residues of the high-boiling second solvent, improving the purity of the recovered lead iodide, avoiding high energy consumption, improving the stability and efficiency of lead iodide recovery, and being suitable for industrialized recovery.

The method for recovering lead iodide from a perovskite solar battery in an embodiment of this application is applicable to recovering lead iodide from a perovskite solar battery and recycling lead iodide from perovskite offcuts. The recovered lead iodide may be used as a perovskite precursor for preparing perovskite again, or for other purposes as lead iodide.

For ease of description, a method and a corresponding recycling system for recovering lead iodide from, for example, a perovskite solar battery are described below according to an embodiment of this application.

According to a first aspect, an embodiment of this application provides a method for recovering lead iodide from a perovskite solar battery. As shown in FIG. 2, the method includes the following steps:
Step S01: Pretreating a recycled perovskite solar battery to obtain perovskite;
Step S02: Putting the perovskite into a second solvent to dissolve lead iodide and obtain a lead iodide-containing solution; and
Step S03: Mixing the lead iodide-containing solution with a third solvent to precipitate the lead iodide, and collecting a lead iodide precipitate, where a boiling point of the third solvent is lower than a boiling point of the second solvent.

In this way, in the method for recovering lead iodide from a perovskite solar battery in an embodiment of this application, the lead iodide is dissolved out from the perovskite first, and then the lead iodide is directly separated from the second solvent by a precipitation method by using a relatively low-boiling third solvent as a counter-solvent, thereby significantly reducing or avoiding the residue of the second solvent or the like in the lead iodide, effectively improving the purity of the lead iodide precipitate, and improving the recovery rate of the lead iodide. Because high-temperature distillation is avoided, the energy consumption is reduced effectively, the recovery process is simplified, the stability of lead iodide recovery is improved, and the method is suitable for industrialized recovery. The boiling point of the third solvent is lower than that of second solvent. Therefore, the third solvent and the second solvent can be collected separately from a mixed filtrate of the third solvent and the second solvent by a low-temperature separation process after the lead iodide is separated and precipitated, thereby reducing the emission of waste liquid, improving the environment-friendliness, and reducing the economic cost.

### Step S01:

In step S01, the perovskite solar battery to be recycled is pretreated to disassemble the perovskite solar battery and separate a perovskite function layer, such as the perovskite layer in FIG. 1.

In some embodiments, step S01 by which the recycled perovskite solar battery is pretreated may include the following substeps:
Step S011: Removing a glass layer and an electrode layer from the recycled perovskite solar battery to obtain a solar battery that exposes a transport layer; and
Step S012: Putting the solar battery with the exposed transport layer into a transport layer dissolvent to dissolve the transport layer, and then cleaning the solar battery by using a first solvent, and drying the cleaned product to obtain perovskite.

When the recycled perovskite solar battery is pretreated by the above pretreatment method, other components included in the recycled perovskite solar battery are stripped off effectively. Examples of such other components include the glass layer, the electrode layer, and the transport layer shown in FIG. 1. In this way, the perovskite layer can be separated and collected, the pretreatment efficiency is improved effectively, the perovskite is purified preliminarily, and the recovery rate of lead iodide is improved.

The glass layer and the electrode layer in step S011 may be removed by a mechanical stripping method. For example, in some embodiments, the glass layer may be removed by a heating stripping method, so as to separate the glass layer, that is, the cover glass. For example, in another embodiment, the electrode layer may be stripped off by ripping the electrode layer with a tensile force. Specifically, adhesive tape is bonded to the surface of the electrode layer, and then torn off so that the electrode layer is stripped off by the bonding force between the tape and the electrode layer.

The transport layer dissolution in step S012 is to dissolve and remove the transport layer by a solvent method, so as to obtain perovskite, that is, obtain a perovskite layer component shown in FIG. 1. For example, the transport layer includes functional layers such as an electron transport layer and a hole transport layer shown in FIG. 1. In some embodiments, the step of putting the solar battery with an exposed transport layer into a transport layer dissolvent to dissolve the transport layer may be accompanied by ultrasonication. The ultrasonication applied additionally can increase the dissolution rate and dissolved amount of the transport layer in the transport layer dissolvent, maximally remove the transport layer, and avoid the adverse effect exerted by the transport layer on the subsequent recovery of lead iodide. In a further embodiment, the conditions of the ultrasonication that accompanies the transport layer dissolution may be at least one of the following conditions: frequency: 1 to 10 kHz; temperature: 20 °C to 80 °C; and time: 1 to 20 min. The ultrasonication under such conditions improves the dissolution rate of the transport layer.

The transport layer dissolvent in step S012 is a solvent capable of dissolving the transport layer including the electron transport layer and the hole transport layer. For example, in some embodiments, the transport layer dissolvent may include at least one of chlorobenzene, methylbenzene, dichlorobenzene, ethyl acetate, or dimethylbenzene. These transport layer dissolvents can effectively dissolve the transport layer such as the electron transport layer and the hole transport layer, separate the transport layer from the superficial layer of the perovskite layer, and reduce the residuals of the transport layer material, thereby improving the purity of the perovskite, and in turn, improving the purity of the recovered lead iodide.

Furthermore, in the step of dissolving the transport layer, the transport layer dissolvent needs to be sufficient for the solar battery with an exposed transport layer. In addition, the dissolution time of the transport layer needs to be enough to sufficiently dissolve out the transport layer and the like, so as to improve the purity of the perovskite.

The cleaning process in step S012 is intended to remove the residual transport layer dissolvent that remains on the perovskite, and at least partially remove other constituents contained in the perovskite, such as A-site elemental constituents contained in the perovskite, so as to purify the perovskite.

Therefore, in some embodiments, the first solvent used for performing the cleaning in step S012 needs to be a solvent at least miscible with the transport layer dissolvent, and the first solvent is a low-boiling solvent that boils at a boiling point lower than the second solvent. In other words, the boiling point of the first solvent is lower than the boiling point of the second solvent. In some embodiments, the first solvent may include at least one of alcohol, ketone, ether, ester, or aromatic hydrocarbon. These types of first solvents are well miscible with the transport layer dissolvent, and can effectively improve the capability of dissolving the residual transport layer dissolvent, dissolve at least some A-site constituents in the perovskite, and be easily dried at a low temperature without leaving residues in the perovskite.

In an example, when the first solvent includes an alcohol, the alcohol may include at least one of ethanol, methanol, propanol, or butanol. When the first solvent includes a ketone, the ketone may include at least one of acetone or butanone. When the first solvent include an ether, the ether includes at least one of methyl ether, methyl ethyl ether, ethyl ether, or petroleum ether. When the first solvent includes an ester, the ester includes at least one of methyl formate, ethyl formate, methyl acetate, or ethyl acetate. When the first solvent includes an ester, the aromatic hydrocarbon includes at least one of hexane, pentane, or heptane. These types of alcohols, ketones, ethers, esters, aromatic hydrocarbons and the like are well miscible with the transport layer dissolvent such as the solvents like chlorobenzene, methylbenzene, dichlorobenzene, and ethyl acetate, and can effectively dissolve the transport layer dissolvent that remain in the perovskite, and dissolve at least some A-site constituents in the perovskite. Moreover, such solvents boil at a low boiling point, and can be effectively removed at a low temperature without leaving residues, thereby improving the purity of the perovskite.

In some embodiments, the step of cleaning by using a first solvent may be accompanied by ultrasonication. The ultrasonication applied additionally can increase the dissolution rate and dissolved amount of the residual transport layer dissolvent or at least some A-site constituents in the perovskite or the like in the first solvent, and maximally remove the impurities contained in the perovskite, so as to prevent the impurities from adversely affecting the subsequent recovery of lead iodide. In a further embodiment, the conditions of the ultrasonication that accompanies the cleaning process may be at least one of the following conditions: frequency: 1 to 10 kHz; temperature: 20 °C to 80 °C; and time: 1 to 20 min. The ultrasonication under such conditions improves the cleaning effect, increases the quantity of some A-site constituents in the perovskite dissociated from the perovskite and entering the first solvent, and in turn, improves the purity of the perovskite in step S01, and reduces the content of impurities in the lead iodide solution in step S02.

Furthermore, in the step of cleaning, the first solvent needs to be sufficient for the solar battery subjected to the transport layer dissolution. In addition, the cleaning time needs to be enough to sufficiently dissolve out the transport layer and the like, so as to improve the purity of the perovskite.

The drying process in step S012 is intended to remove the first solvent that remains in the perovskite. The drying process can occur under any conditions as long as the first solvent can be evaporated, for example, evaporated naturally or oven-dried at a low temperature.

### Step S02:

In step S02, in a process of dissolving the lead iodide in the perovskite pretreated by step S01, the lead iodide contained in the perovskite can be dissolved in the second solvent. To be specific, the lead iodide is dissociated from the perovskite and dissolved in the second solvent to form a lead iodide-containing solution.

Therefore, the second solvent needs to be a solvent that can effectively dissolve the lead iodide. For example, in some embodiments, the second solvent may include a complexing solvent. The complexing solvent can be complexed with the lead iodide to form a complex, thereby effectively increasing the amount of dissolved lead iodide and improving the stability of the lead iodide solution. The complexing solvent, which can be complexed with the lead iodide to form a complex, is selected as the second solvent to effectively dissolve and dissociate the lead iodide from the perovskite, thereby effectively increasing the amount of dissolved lead iodide, improving stability of the lead iodide solution, effectively improving the dissociation rate of lead iodide from the perovskite, and improving the recovery rate of lead iodide.

In an example, the complexing solvent may include dimethyl sulfoxide (DMSO) or a mixed solvent formed by mixing dimethyl sulfoxide with at least one of N,N-dimethylformamide (DMF), N-methyl-pyrrolidone (NMP), or y-butyrolactone (GBL). These complexing solvents can be complexed with lead iodide to form a stable complex, and can increase the complexed amount of lead iodide, the stability and amount of dissolved lead iodide, and the recovery rate of lead iodide. For example, in an example, when the complexing solvent is dimethyl sulfoxide, the lead iodide is complexed with the dimethyl sulfoxide to form a complex PbI₂·DMSO.

In some embodiments, the step of dissolving lead iodide by using a second solvent may be accompanied by ultrasonication. The ultrasonication applied additionally can increase the dissolution rate and dissolved amount of the lead iodide solvent in the first solvent, thereby increasing the recovery rate and recovery efficiency of lead iodide. In a further embodiment, the conditions of the ultrasonication that accompanies the lead iodide dissolution may be at least one of the following conditions: frequency: 1 to 10 kHz; temperature: 20 °C to 80 °C; and time: 1 to 20 min. The ultrasonication under such conditions improves the dissolution rate of the lead iodide from the perovskite.

The content of perovskite contained in a perovskite solar cell is generally not high. Therefore, in some embodiments, during the lead iodide dissolution in step S02, a plurality of sheets of perovskite already treated by step S01 may be placed together into a second solvent to dissolve lead iodide. In other words, the perovskite includes a plurality of sheets, and the plurality of sheets are placed together in a second solvent to dissolve lead iodide.

The perovskite solar cell means a perovskite solar battery containing a conductive glass electrode, a hole transport layer, a perovskite light-absorbing layer, an electron transport layer, and a counter electrode stacked in sequence, for example, the perovskite solar battery shown in FIG. 1. Placing a plurality of sheets of perovskite together to dissolve lead iodide can effectively improve the efficiency of the lead iodide dissolution, save the amount of the second solvent used, and improve the extraction efficiency of the lead iodide.

Furthermore, in the step of lead iodide dissolution, the second solvent needs to be sufficient for the perovskite. In addition, the dissolution time of lead iodide needs to be enough so that the lead iodide contained in the perovskite can be sufficiently dissolved and enter the second solvent, thereby improving the recovery rate and recovery efficiency of lead iodide. In an example, when the second solvent is the above-mentioned dimethyl sulfoxide, a plurality of sheets of perovskite already treated by step S01 are placed together in the dimethyl sulfoxide to dissolve lead iodide, accompanied by ultrasonication until the dimethyl sulfoxide changes from colorless to dark yellow. The dimethyl sulfoxide turning to a dark yellow color is an indicator of completing the lead iodide dissolution.

After completing the dissolution of lead iodide in step S02, some insoluble matters enter the lead iodide-containing solution. Therefore, in some embodiments, the method further includes a step of solid-liquid separation for the lead iodide-containing solution. In an example, the lead iodide-containing solution may be filtered, and specifically, suction-filtered, to remove the insoluble matters.

### Step S03:

In step S03, the third solvent is mixed with the lead iodide-containing solution mentioned in step S02, so as to precipitate the lead iodide. When the second solvent in step S02 is a complexing solvent, the complexing solvent is complexed with the lead iodide to form a complex in the complexing agent. After the third solvent is mixed with the lead iodide-containing solution, the third solvent disrupts the structure of the complex in the lead iodide-containing solution, and the lead iodide is insoluble in the third solvent, so that the lead iodide precipitates. Based on the role of the third solvent acting in step S03, the third solvent acts as a counter-solvent. The boiling point of the third solvent is lower than that of the second solvent, and the third solvent is a polar solvent, thereby maximally precipitating the lead iodide. Therefore, after completion of precipitating the lead iodide, the third solvent and the second solvent can be collected separately from a mixed filtrate of the third solvent and the second solvent by being separated at a low temperature, thereby reducing the emission of waste liquid generated during the recovery of lead iodide.

Based on the above role of the third solvent, the third solvent means a solvent that at least does not dissolve lead iodide. Definitely, the boiling point of the third solvent is lower than that of the second solvent. For example, in some embodiments, the third solvent may include at least one of alcohol, ketone, ether, ester, or aromatic hydrocarbon. These solvents boil at a low boiling point, and can effectively induce precipitation and separation of lead iodide from the second solvent, and are easily separated and collected from the second solvent at a low temperature.

In an example, when the third solvent includes an alcohol, the alcohol may include at least one of ethanol, methanol, propanol, or butanol. When the third solvent includes a ketone, the ketone may include at least one of acetone or butanone. When the third solvent include an ether, the ether includes at least one of methyl ether, methyl ethyl ether, ethyl ether, or petroleum ether. When the third solvent includes an ester, the ester includes at least one of methyl formate, ethyl formate, methyl acetate, or ethyl acetate. When the third solvent includes an ester, the aromatic hydrocarbon includes at least one of hexane, pentane, or heptane. These alcohols, ketones, ethers, esters, aromatic hydrocarbons, and the like used as solvents boil at a low boiling point, and are highly effective in precipitating and separating the lead iodide and in recovering and collecting the lead iodide at a low temperature.

In an embodiment, with respect to the manner of mixing the lead iodide-containing solution with the third solvent, a relatively sufficient amount of the third solvent may be well mixed with the lead iodide-containing solution directly, or the third solvent may be added dropwise into the lead iodide-containing solution and well mixed.

Regardless of the manner of mixing the third solvent and the lead iodide-containing solution, in some embodiments, the third solvent needs to be sufficient relative to the second solvent. For example, the third solvent keeps being added until no precipitate is generated from the mixed solvent. Once the precipitation phenomenon stops, the third solvent continues to be added to allow the lead iodide in the lead iodide-containing solution to precipitate sufficiently, thereby increasing the recovery rate of the lead iodide.

When the mixing process, that is, the precipitation of the lead iodide, is completed in step S03, a solid-liquid separation process is performed to separate the lead iodide precipitate from the mixed filtrate of the second solvent and the third solvent in order to collect the lead iodide precipitate. Therefore, in some embodiments, the solid-liquid separation may be centrifugalization, filtration, or the like.

In a further embodiment, when collecting the lead iodide precipitate, the method further includes the following recycling steps for a mixed filtrate containing the second solvent and the third solvent:
Step S031: Fractionating the mixed filtrate to obtain a recovered second solvent and a recovered third solvent separately.
Step S032: Introducing the recovered second solvent into the process of lead iodide dissolution, and introducing the recovered third solvent into the process of mixing the lead iodide-containing solution with the third solvent.

By fractionating the mixed filtrate based on the difference in the boiling point between the second solvent and the third solvent contained in the mixed filtrate, the relatively low-boiling third solvent is distilled, so that the second solvent and the third solvent can be separated. In other words, the second solvent and the third solvent are collected and recycled separately. Subsequently, the second solvent and the third solvent are reused separately in place of a part of the above-mentioned second solvent and the third solvent respectively, thereby effectively reducing the amount of the above-mentioned second solvent and third solvent used, effectively saving the solvents, reducing the economic cost, reducing the emission of waste liquid during the recovery of the lead iodide, and improving the environment-friendliness.

For the fractionation in step S031, fractionation conditions may be set based on the boiling point characteristics of the third solvent. The boiling point of the third solvent is lower than the boiling point of the second solvent. Therefore, the two solvents can be separated at a relatively low temperature.

In step S032, the introducing the recovered second solvent into the process of lead iodide dissolution is to let the recovered second solvent replace a part of the above-mentioned second solvent, so as to recycle and reuse the recovered second solvent, effectively improve the use efficiency of the second solvent, reduce the total amount of the second solvent used in the method for recovering lead iodide from a perovskite solar battery in an embodiment of this application, and in turn, reduce the cost of recovering the lead iodide.

In step S032, the introducing the recovered third solvent into the process of mixing the lead iodide-containing solution with the third solvent is to let the recovered third solvent replace a part of the above-mentioned third solvent, so as to recycle and reuse the recovered third solvent, effectively improve the use efficiency of the third solvent, reduce the total amount of the third solvent used in the method for recovering lead iodide from a perovskite solar battery in an embodiment of this application, and in turn, reduce the recovery cost of the lead iodide.

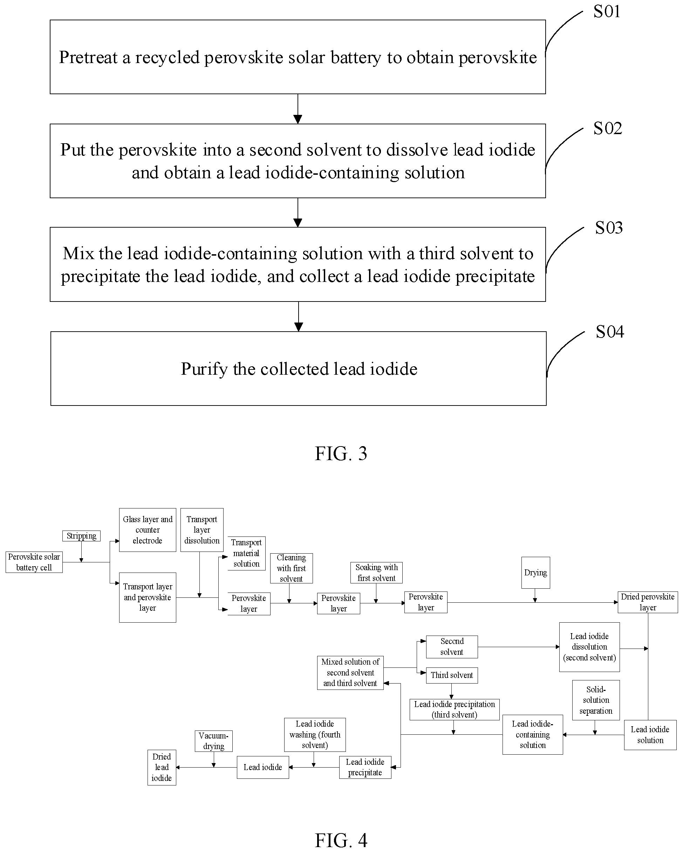

In some embodiments, after the step of collecting a lead iodide precipitate, the method further includes step S04 shown in FIG. 3 to purify the collected lead iodide precipitate: washing the lead iodide precipitate for at least one time by using a fourth solvent.

Purification of the lead iodide precipitate can effectively remove the second solvent that remains in the lead iodide precipitate, and further effectively reduce the content of impurities and further improve the purity of the lead iodide.

Based on the purification process and the above role of the fourth solvent, the fourth solvent means a solvent miscible with the second solvent but incapable of dissolving lead iodide. Definitely, the boiling point of the fourth solvent is lower than that of the second solvent, and the fourth solvent is a polar solvent that scarcely dissolves the lead iodide so as to maximally precipitate the lead iodide. For example, in some embodiments, the fourth solvent may include at least one of alcohol, ketone, ether, ester, or aromatic hydrocarbon. These solvents boil at a low boiling point and can effectively dissolve the second solvent and other impurities that remain in the lead iodide precipitate, so as to purify the lead iodide precipitate.

In an example, when the fourth solvent includes an alcohol, the alcohol may include at least one of ethanol, methanol, propanol, or butanol. When the fourth solvent includes a ketone, the ketone may include at least one of acetone or butanone. When the fourth solvent include an ether, the ether includes at least one of methyl ether, methyl ethyl ether, ethyl ether, or petroleum ether. When the fourth solvent includes an ester, the ester includes at least one of methyl formate, ethyl formate, methyl acetate, or ethyl acetate. When the fourth solvent includes an ester, the aromatic hydrocarbon includes at least one of hexane, pentane, or heptane. These types of alcohols, ketones, ethers, esters, aromatic hydrocarbons, and the like do not dissolve lead iodide but strongly dissolve the impurities such as the second solvent, boil at a low boiling point, and are highly effective in recovering and collecting the lead iodide at a low temperature.

The washing operation in this step may be performed for one, two or more times, and ideally at least two times until the lead iodide precipitate takes on a bright yellow color, so as to improve the purity of the lead iodide precipitate.

Upon completion of each washing operation, a solid-liquid separation process is performed to separate the lead iodide precipitate from the fourth solvent, so as to collect the purified lead iodide precipitate. In some embodiments, the solid-liquid separation may be centrifugalization, filtration, or the like. The filtration may be suction-filtration.

After the above step of purification is completed, the purified lead iodide precipitate may be subjected to a drying process to obtain dried lead iodide. In an example, the drying process for the lead iodide precipitate may be low-temperature drying in a vacuum environment. For example, the temperature for the low-temperature drying is a temperature suitable for evaporation of the fourth solvent.

On the basis of all the above embodiments, in some embodiments, the first solvent, the third solvent, and the fourth solvent in all the above steps each independently are an alcohol solvent, for example, at least one of ethanol, methanol, propanol, or butanol. The second solvent is dimethyl sulfoxide. By controlling the first solvent, the third solvent, and the fourth solvent each independently to be the low-boiling alcohol solvents, the impurities can be effectively removed from the lead iodide during recycling, thereby improving the purity of the lead iodide. Moreover, the solvents are easily recyclable, for example, may be further reused. At the same time, the dimethyl sulfoxide is selected as the second solvent, so that dimethyl sulfoxide and such alcohols play a role in enhancing the efficiency, thereby improving the recovery rate of the lead iodide in addition to the purity of the lead iodide.

Based on the above embodiments, in an example, a method for recovering lead iodide from a perovskite solar battery in an embodiment of this application may include the following steps, as shown in FIG. 4:
Step S01: Stripping a perovskite solar cell to obtain components including a transport layer and a perovskite layer;
Step S011: Stripping off a glass layer and a counter electrode: heating the perovskite solar cell and mechanically strip off the glass layer, and then removing the counter electrode by means of mechanical stripping; and
Step S012: Separating the perovskite layer.

Transport layer dissolution: Using a transport layer dissolvent to soak the perovskite solar battery treated by step S011, and dissolving the transport layer to obtain a perovskite layer, where the transport layer dissolvent is the above-mentioned transport layer dissolvent, and specifically, may be chlorobenzene, and the transport layer dissolution process may be accompanied by ultrasonication.

Perovskite layer cleaning: Cleaning, by using a first solvent, the perovskite layer obtained by dissolving the transfer layer, where the first solvent is the above-mentioned first solvent, and specifically may be ethanol, and the cleaning process may be accompanied by ultrasonication.

Perovskite layer drying: Drying the cleaned perovskite layer by means of oven-drying.

### Step S02: Lead iodide dissolution:

Using a second solvent to dissolve the perovskite layer treated by step S012, and then performing solid-liquid separation to obtain a lead iodide-containing solution, where the second solvent is the above-mentioned second solvent, and specifically, may be dimethyl sulfoxide, this step S02 may be accompanied by ultrasonication, and the solid-liquid separation may be centrifugalization.

### Step S03: Lead iodide precipitation:

Mixing the lead iodide-containing solution with a third solvent to precipitate the lead iodide, and then performing solid-liquid separation to collect a lead iodide precipitate and collect a mixed filtrate containing the second solvent and the third solvent, where the third solvent is the above-mentioned third solvent, and specifically may be ethanol, and the solid-liquid separation may be centrifugalization.

Further, fractionating the mixed filtrate of the second solvent and the third solvent to collect the recovered second solvent and the recovered third solvent separately. Introducing the recovered second solvent to step S02 so that the recovered second solvent is reused to dissolve the perovskite layer. Introducing the recovered third solvent to step S03 so that the recovered third solvent is reused to mix with the lead iodide-containing solution to precipitate the lead iodide.

### Step S04: Lead iodide purification:

Step S041: Washing the lead iodide. Specifically, washing the lead iodide precipitate for several times by using a fourth solvent, where the fourth solvent is the above-mentioned fourth solvent, and specifically may be ethanol, and the solid-liquid separation performed after each washing operation may be centrifugalization.

Step S042: Vacuum-drying. Specifically, vacuum-drying the purified lead iodide precipitate to obtain dried lead iodide.

In the method for recovering lead iodide from a perovskite solar battery in an embodiment of this application, through the steps shown in FIG. 4, the perovskite can be separated from the perovskite solar battery efficiently, and the lead iodide is extracted from the perovskite. A high purity and a high recovery rate of lead iodide are ensured. The purity, the recovery rate, and the chemical properties of the recovered lead iodide are stable, and the recovery rate is high. Further, the mixed filtrate of the second solvent and the third solvent is fractionated, and the collected second solvent and third solvent are recycled and reused, thereby improving the utilization rate of the solvent, reducing the emissions of the waste liquid, and reducing the recycling cost of the lead iodide.

The lead iodide recovered by the method for recovering lead iodide from a perovskite solar battery in all the above embodiments is tested. The test results show that in some embodiments, the lead iodide at least exhibits any one of the following characteristics. The purity and thermal weight loss of the lead iodide may be shown in Table 1 below:
The crystallographic orientation of the lead iodide is (0 0 1);
The purity of the lead iodide is 99.1 mol% or higher;
The particle radius of the lead iodide is less than 100 µm;
The thermal weight loss of the lead iodide is less than 0.7 wt%; or
The solubility of the lead iodide in a DMF solvent is 0.5 g/ml.

Therefore, the lead iodide recovered by the method for recovering lead iodide from a perovskite solar battery in an embodiment of this application exhibits a low crystallographic orientation, a high purity, and a high solubility. The crystalline orientation of the lead iodide may be tested by a crystallographic orientation test method in the industry, such as a corrosion method, a laser orientation method, or an X-ray diffraction method. The crystallographic orientation of the lead iodide recovered by the method for recovering lead iodide from a perovskite solar battery in an embodiment of this application is (0 0 1), reflecting a high degree of consistent orientation. Therefore, when being put into use for preparing perovskite, the recovered lead iodide endows the perovskite with a high degree of consistent orientation. In addition, the recovered lead iodide is of a high purity, a small particle diameter, and high solubility, thereby improving the photoelectric properties of the perovskite.

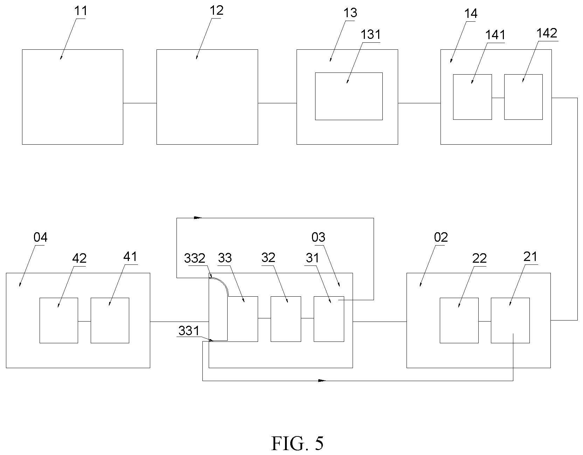

According to a second aspect, an embodiment of this application provides a recycling system for recovering lead iodide from a perovskite solar battery. As shown in FIG. 5, the recycling system for recovering lead iodide from a perovskite solar battery according to an embodiment of this application includes:
a recycled perovskite solar battery stripping apparatus 01, configured to strip the recycled perovskite solar battery to recover perovskite;
a lead iodide extraction apparatus 02, configured to extract lead iodide from the perovskite by a solvent method; and
a lead iodide precipitate separation apparatus 03, configured to perform precipitation on the lead iodide-containing solution obtained through treatment by the lead iodide extraction apparatus 02, so as to obtain the lead iodide precipitate.

The recycled perovskite solar battery stripping apparatus 01 is configured to pretreat the recycled perovskite solar battery, and specifically, remove other components of the perovskite solar battery and collect the perovskite layer component, as described above in step S01 of the method for recovering lead iodide from a perovskite solar battery in an embodiment of this application.

The lead iodide extraction apparatus 02 is configured to extract, by using a solvent method, a lead iodide from the perovskite obtained through treatment by the recycled perovskite solar battery stripping apparatus 01. The specific extraction operation is the same as step S02 in the above-mentioned method for recovering lead iodide from a perovskite solar battery in an embodiment of this application, so as to separate the lead iodide from other constituents of the perovskite and collect the lead iodide-containing solution.

The lead iodide precipitate separation apparatus 03 is configured to perform lead iodide precipitation on the lead iodide-containing solution obtained through treatment by the lead iodide extraction apparatus 02. The specific precipitation operation is the same as step S03 in the above-mentioned method for recovering lead iodide from a perovskite solar battery in an embodiment of this application, so as to precipitate the lead iodide from the lead iodide-containing solution, separate the lead iodide from the solvent, and collect the lead iodide precipitate.

Therefore, the recycling system for recovering lead iodide from a perovskite solar battery in an embodiment of this application is configured to implement the method for recovering lead iodide from a perovskite solar battery in an embodiment of this application. The recycled perovskite solar battery stripping apparatus 01, lead iodide extraction apparatus 02, and lead iodide precipitate separation apparatus 03 included in the recycling system are connected sequentially in such order that step S01, step S02, and step S03 of the method for recovering lead iodide from a perovskite solar battery in an embodiment of this application are performed sequentially. The recycling system implements separation of the perovskite and preliminary collection of the lead iodide through the synergistic operations of the recycled perovskite solar battery stripping apparatus 01 and the lead iodide extraction apparatus 02 included in the system. On this basis, the lead iodide precipitate separation apparatus 03 can collect and separate lead iodide by a solvent precipitation method, thereby effectively improving the purity of the recovered lead iodide and the recovery rate, reducing the emission of waste liquid, improving the environmental friendliness of the lead iodide recovery, and reducing the economic cost.

In some embodiments, as shown in FIG. 1, the recycled perovskite solar battery stripping apparatus 01 includes a glass substrate stripping apparatus 11, an electrode separation apparatus 12, a transport layer dissolution apparatus 13, and a perovskite cleaning apparatus 14. The glass substrate stripping apparatus 11, the electrode separation apparatus 12, the transport layer dissolution apparatus 13, and the perovskite cleaning apparatus 14 are connected sequentially in such order that the recycled perovskite solar battery undergoes the following processes sequentially: glass substrate stripping, electrode layer separation, transport layer dissolution, and perovskite cleaning. The perovskite cleaning apparatus 14 is connected to the lead iodide extraction apparatus 02.

The glass substrate stripping apparatus 11 is configured to strip off a glass layer, that is, cover glass, included in the recycled perovskite solar battery. The specific glass layer stripping operation is the same as the corresponding operation in step S011 of the above-mentioned method for recovering lead iodide from a perovskite solar battery in an embodiment of this application. When the glass layer is stripped off by heating, a heating component and a glass stripping component (not shown in FIG. 5) may be disposed on the glass substrate stripping apparatus 11. The heating component is configured to heat the glass layer of the recycled perovskite solar battery. The stripping component acts on the glass layer to separate the glass layer from the electrode.

The electrode separation apparatus 12 is configured to strip off an electrode layer included in the recycled perovskite solar battery. The specific electrode layer stripping operation is the same as the corresponding operation in step S011 of the above-mentioned method for recovering lead iodide from a perovskite solar battery in an embodiment of this application. In a case of mechanical stripping, the electrode separation apparatus 12 may be disposed in the form of an electrode stripping component (not shown in FIG. 5). The electrode layer is stripped by the electrode separation apparatus 12, so that the recovered perovskite solar battery exposes the transport layer including an electron transport layer and a hole transport layer, thereby making it convenient for the transport layer dissolution apparatus 13 to dissolve and strip off the transport layer.

The transport layer dissolution apparatus 13 is configured to dissolve the transport layer including the electron transport layer and the hole transport layer included in the recycled perovskite solar battery, so as to remove the transport layer on the surface of the perovskite layer and obtain the perovskite layer. The specific transport layer dissolution operation is the same as the corresponding operation in step S012 of the above-mentioned method for recovering lead iodide from a perovskite solar battery in an embodiment of this application. Therefore, in some embodiments, the transport layer dissolution apparatus 13 includes at least a transport layer dissolution vessel 131 configured to accommodate the above-mentioned transport layer dissolvent, and immerse the solar battery with an exposed transport layer into the transport layer dissolvent to dissolve the transport layer. In a further embodiment, an ultrasonication component (not shown in FIG. 5) is disposed on the transport layer dissolution apparatus 13, and is configured to sonicate the transport-layer-containing perovskite contained in the transport layer dissolution vessel 131, so as to improve the effect and efficiency of the transport layer dissolvent in dissolving the transport layer.

The perovskite cleaning apparatus 14 is configured to clean the perovskite layer included in the recycled perovskite solar battery. The specific perovskite layer cleaning operation is the same as the corresponding operation in step S012 of the above-mentioned method for recovering lead iodide from a perovskite solar battery in an embodiment of this application. Therefore, in some embodiments, the perovskite cleaning apparatus 14 includes at least a cleaning component 141 configured to cleaning the perovskite and a drying component 142 configured to dry the perovskite. The cleaning component 141 and the drying component 142 are connected sequentially in the perovskite cleaning apparatus 14 in such order that the cleaning occurs before drying. In a further embodiment, an ultrasonication component (not shown in FIG. 5) is disposed on the perovskite cleaning apparatus 14, and is configured to sonicate the perovskite in the cleaning component 141, so as to improve the effect and efficiency of cleaning the perovskite.

In the recycled perovskite solar battery stripping apparatus 01, the glass substrate stripping apparatus 11, the electrode separation apparatus 12, the transport layer dissolution apparatus 13, and the perovskite cleaning apparatus 14 are connected sequentially, so as to perform the glass substrate stripping, electrode separation, transport layer dissolution, perovskite cleaning, and the like sequentially for the recycled perovskite solar battery, thereby preliminarily purifying the perovskite, improving the recovery rate of the lead iodide, and improving the pretreatment efficiency.

In some embodiments, as shown in FIG. 1, the lead iodide extraction apparatus 02 includes at least a lead iodide dissolution vessel 21 configured to accommodate the above-mentioned second solvent, and immerse the perovskite into the second solvent to dissolve the lead iodide, where the perovskite is obtained through treatment by the recycled perovskite solar battery stripping apparatus 01. In a further embodiment, a first solid-liquid separation component 22 is further disposed on the lead iodide extraction apparatus 02. The lead iodide dissolution vessel 21 and the first solid-liquid separation component 22 are connected sequentially in such order that the lead iodide dissolution occurs before the solid-liquid separation. In a further embodiment, an ultrasonication component (not shown in FIG. 5) is disposed on the lead iodide extraction apparatus 02, and is configured to sonicate the perovskite contained in the lead iodide dissolution vessel 21, so as to improve the effect and efficiency of dissolving the lead iodide.

In some embodiments, as shown in FIG. 1, the lead iodide precipitate separation apparatus 03 includes at least a lead iodide precipitation vessel 31 configured to accommodate the above-mentioned third solvent and perform lead iodide precipitation on the lead iodide-containing solution obtained through treatment by the lead iodide extraction apparatus 02. In a further embodiment, a second solid-liquid separation component 32 is further disposed on the lead iodide precipitate separation apparatus 03. The lead iodide precipitation vessel 31 and the second solid-liquid separation component 32 are connected sequentially in such order that the lead iodide precipitation occurs before the solid-liquid separation. In this way, during the precipitation of the lead iodide, the lead iodide is precipitated first, and then the solid is separated from the liquid, so as to collect the lead iodide precipitate and a mixed solution separately, where the mixed solution contains the second solvent and the third solvent. In this case, the lead iodide precipitation vessel 31 is connected to a solution outlet of the lead iodide dissolution vessel 21 included in the lead iodide extraction apparatus 02, and is configured to introduce the lead iodide-containing solution into the lead iodide precipitation vessel 31 for lead iodide precipitation, where the lead iodide-containing solution is formed in the lead iodide dissolution vessel 21. When the lead iodide extraction apparatus 02 includes the first solid-liquid separation component 22, the lead iodide precipitation vessel 31 is connected to a solution outlet of the first solid-liquid separation component 22, and is configured to introduce the lead iodide-containing solution into the lead iodide precipitation vessel 31 for lead iodide precipitation, where the lead iodide-containing solution has undergone solid-liquid separation.

In a further embodiment, the lead iodide precipitate separation apparatus 03 further includes a fractionation component 33. The fractionation component 33 is connected to a solution outlet of the second solid-liquid separation component 32, and is configured to fractionate a mixed filtrate of the second solvent and the third solvent separated and collected by the second solid-liquid separation component 32, so that the second solvent and the third solvent included in the mixed filtrate are separated to obtain a recovered second solvent and a recovered third solvent, respectively. Therefore, the fractionation component 33 includes at least a second solvent outlet 331 and a third solvent outlet 332.

In the example, the third solvent outlet 332 of the fractionation component 33 is connected to the lead iodide dissolution vessel 21 of the lead iodide extraction apparatus 02, and is configured to introduce the recovered second solvent into the lead iodide extraction apparatus 02 for lead iodide extraction, where the recovered second solvent is fractionated by the fractionation component 33. The third solvent outlet 331 of the fractionation component 33 is connected to the lead iodide precipitation vessel 31 of the lead iodide precipitate separation apparatus 03, and is configured to introduce the recovered third solvent into the lead iodide precipitation vessel 31 for lead iodide precipitation, where the recovered third solvent is fractionated by the fractionation component 33. By disposing the fractionation component 33, connecting the third solvent outlet 332 to the lead iodide dissolution vessel 21, and connecting the third solvent outlet 331 to the lead iodide precipitation vessel 31, this application implements reuse of the second solvent and the third solvent separately, thereby effectively reducing or avoiding emissions of the waste liquid during the lead iodide recovery, improving environment-friendliness and safety, and reducing the economic cost.

In some embodiments, as shown in FIG. 1, the recycling system for recovering lead iodide from a perovskite solar battery further includes a lead iodide purification apparatus 04. The lead iodide purification apparatus 04 is connected to the lead iodide precipitate separation apparatus 03, and is configured to purify the lead iodide precipitate treated by the lead iodide precipitate separation apparatus 03, thereby improving the purity of the recovered lead iodide.

In a further embodiment, the lead iodide purification apparatus 04 includes at least a lead iodide washing component 41 and a vacuum-drying component 42. The lead iodide washing component 41 and the vacuum-drying component 42 are connected sequentially in the lead iodide purification apparatus 04 in such order that the lead iodide is washed before the vacuum-drying. The lead iodide washing component 41 is configured to wash and purify the lead iodide precipitate obtained through treatment by the lead iodide precipitate separation apparatus 03, so as to remove impurities. The vacuum-drying component 42 is configured to vacuum-dry the lead iodide washed by the lead iodide washing component 41.

### Embodiments

The following describes some embodiments of this application. The embodiments described below are illustrative, and are merely intended to construe this application but not to limit this application. Unless techniques or conditions are otherwise expressly specified in an embodiment hereof, the techniques or conditions described in the literature in this field or in an instruction manual of the product are applicable in the embodiment. A reagent or instrument used herein without specifying a manufacturer is a conventional product that is commercially available in the market.

### Embodiment 1

This embodiment of this application provides a method for recovering lead iodide from a perovskite solar battery. The method includes the following steps:
S1: Pretreating a recycled perovskite solar cell;
   S11: Placing the recycled perovskite solar cell into an oven, and heating the solar cell at 150 °C for 10 min, taking out the solar cell after wearing heat insulation gloves, and then uncovering the cover glass;
   S12: Applying adhesive tape to the metal electrode when the glass is cooled down to a room temperature, so as to expose the transport layer;
   S13: Soaking the solar cell with an exposed transport layer in chlorobenzene, performing ultrasonication for 30 s, and then taking out the solar cell; and
   S14: Transferring the glass into ethanol, performing ultrasonication for 10 s, taking out the glass, and placing the glass into an oven to dry the ethanol at a temperature of 70 °C for 10 min to obtain a dry perovskite layer.
S2: Lead iodide dissolution:
   Transferring multiple sheets of perovskite layers pretreated by step S1 into DMSO, performing ultrasonication until the perovskite layer becomes transparent and until the DMSO solution turns dark yellow, and suction-filtering the solution to remove insoluble impurities and collect a lead iodide-containing solution.
S3: Lead iodide precipitation:
   S31: Adding the lead iodide-containing solution in step S2 into a sufficient amount of ethanol to perform precipitation, and then adding dropwise the lead iodide-containing solution in step S2 until precipitation stops, stopping addition of the lead iodide-containing solution, and adding ethanol to ensure that the lead iodide is completely precipitated; and
   S32: Transferring the lead iodide-containing precipitate in step S31 into a centrifuge tube, centrifuging the lead iodide-containing precipitate at a speed of 3000 rpm for 5 min, and collecting a lower-layer lead iodide precipitate.
S4: Lead iodide purification:
   S41: Adding ethanol into the lead iodide precipitate, shaking the solution well, and continuing to centrifuge the lead iodide precipitate at a speed of 3000 rpm for 5 min. Washing, when the lower-layer precipitate turns yellow, the precipitate for one time by using water, and then washing the precipitate for another time by using ethanol.
   S41: Placing the washed lead iodide precipitate into a vacuum-drying oven, and vacuum-drying the precipitate at 80 °C for 3 h to obtain lead iodide powder.

### Embodiment 2

This embodiment provides a method for recovering lead iodide from a perovskite solar battery. The method for recovering lead iodide from a perovskite solar battery in this embodiment differs from the method in Embodiment 1 in that, in the process of lead iodide dissolution in step S2, DMSO in step S2 of Embodiment 1 is replaced with a mixture of DMF: DMSO = 1: 4.

### Embodiment 3

This embodiment provides a method for recovering lead iodide from a perovskite solar battery. The method for recovering lead iodide from a perovskite solar battery in this embodiment differs from the method in Embodiment 1 in that the ethanol in step S31 and step S41 of Embodiment 1 is replaced with methanol.

### Embodiment 4

This embodiment of this application provides a method for recovering lead iodide from a perovskite solar battery. The method for recovering lead iodide from a perovskite solar battery in this embodiment differs from the method in Embodiment 1 in that the lead iodide precipitate obtained by centrifugation in step S32 is directly dried at 150 °C. In other words, step S4 "lead iodide purification" is omitted in contrast to Embodiment 1.

### Embodiment 5

This embodiment of this application provides a method for recovering lead iodide from a perovskite solar battery. The method for recovering lead iodide from a perovskite solar battery in this embodiment differs from the method in Embodiment 1 in that the solar battery soaked in benzene in step S13 is directly subjected to treatments in step S2 and subsequent steps. In other words, the ethanol cleaning operation in step S14 is omitted in contrast to Embodiment 1.

### Embodiment 6

S1: Pretreating a recycled perovskite solar cell;
   S11: Placing the recycled perovskite solar cell into an oven, and heating the solar cell at 150 °C for 10 min, taking out the solar cell after wearing heat insulation gloves, and then uncovering the cover glass;
   S12: Applying adhesive tape to the metal electrode when the glass is cooled down to a room temperature, so as to expose the transport layer;
   S13: Soaking the solar cell with an exposed transport layer in chlorobenzene, performing ultrasonication for 30 s, and then taking out the solar cell; and
   S14: Transferring the glass into ethanol, performing ultrasonication for 10 s, taking out the glass, and placing the glass into an oven to dry the ethanol at a temperature of 70 °C for 10 min to obtain a dry perovskite layer.
S2: Lead iodide dissolution:
   Transferring multiple sheets of perovskite layers pretreated by step S1 into DMSO, performing ultrasonication until the perovskite layer becomes transparent and until the DMSO solution turns dark yellow, and suction-filtering the solution to remove insoluble impurities and collect a lead iodide-containing solution.
S3: Lead iodide precipitation:
   S31: Adding the lead iodide-containing solution in step S2 into a sufficient amount of ethanol to perform precipitation, and then adding dropwise the lead iodide-containing solution in step S2 until precipitation stops, stopping addition of the lead iodide-containing solution, and adding ethanol to ensure that the lead iodide is completely precipitated; and
   S32: Transferring the lead iodide-containing precipitate in step S31 into a centrifuge tube, centrifuging the lead iodide-containing precipitate at a speed of 3000 rpm for 5 min, and collecting a lower-layer lead iodide precipitate and an upper-layer mixed filtrate of DMSO and ethanol separately.
   S33: Fractionating the mixed filtrate of DMSO and ethanol to obtain recovered DMSO and recovered ethanol separately.
   S34: Introducing the resulting recovered DMSO into step S2 to replace a part of the DMSO solvent, and introducing the resulting recovered ethanol into step S31 to replace a part of the DMSO solvent.
S4: Lead iodide purification:
   S41: Adding ethanol into the lead iodide precipitate, shaking the solution well, and continuing to centrifuge the lead iodide precipitate at a speed of 3000 rpm for 5 min. Washing, when the lower-layer precipitate turns yellow, the precipitate for one time by using water, and then washing the precipitate for another time by using ethanol.
   S41: Placing the washed lead iodide precipitate into a vacuum-drying oven, and vacuum-drying the precipitate at 80 °C for 3 h to obtain lead iodide powder.

### Embodiment 7

This embodiment provides a method for recovering lead iodide from a perovskite solar battery. The method for recovering lead iodide from a perovskite solar battery in this embodiment differs from the method in Embodiment 1 in that, in the process of lead iodide dissolution in step S2, DMSO in step S2 of Embodiment 1 is replaced with a mixture of GBL: DMSO = 1: 4; and the ethanol in steps S14, S31, and S4 is replaced with butanone.

### Embodiment 8

This embodiment provides a method for recovering lead iodide from a perovskite solar battery. The method for recovering lead iodide from a perovskite solar battery in this embodiment differs from the method in Embodiment 1 in that, in the process of lead iodide dissolution in step S2, DMSO in step S2 of Embodiment 1 is replaced with a mixture of NMP: DMSO = 1: 4; and the ethanol in steps S14, S31, and S4 is replaced with ethyl ether.

### Comparative Embodiment 1

This comparative embodiment provides a method for recovering lead iodide from a perovskite solar battery. The method for recovering lead iodide from a perovskite solar battery in this comparative embodiment differs from the method in Embodiment 1 in that, in the process of lead iodide dissolution in step S2, DMSO in step S2 of Embodiment 1 is replaced with DMF, and then steps S3 and S4 are omitted, and the collected lead iodide-containing solution is directly rotary-evaporated and dried to obtain a lead iodide solid.

### Comparative Embodiment 2

This comparative embodiment provides a method for recovering lead iodide from a perovskite solar battery. The method for recovering lead iodide from a perovskite solar battery in this comparative embodiment differs from the method in Embodiment 1 in that the collected lead iodide-containing solution obtained by lead iodide dissolution in step S2 of Embodiment 1 is not subjected to the treatments in steps S3 and S4, but the collected lead iodide-containing solution is directly rotary-evaporated and dried to obtain a lead iodide solid.

### Comparative Embodiment 3

This comparative embodiment provides a method for recovering lead iodide from a perovskite solar battery. The method for recovering lead iodide from a perovskite solar battery in this comparative embodiment differs from the method in Embodiment 1 in that the solar battery, which exposes the transport layer and is obtained in step S12, is directly subjected to treatments in step S2 and subsequent steps, and the DMSO in step S2 is replaced with DMF. In other words, in contrast to Embodiment 1, the treatments in steps S13 and S14 are omitted, and the DMSO in step S2 is replaced with DMF.

### Comparative Embodiment 4

This comparative embodiment provides a method for recovering lead iodide from a perovskite solar battery. The method for recovering lead iodide from a perovskite solar battery in this comparative embodiment differs from the method in Embodiment 1 in that the solar battery, which exposes the transport layer and is obtained in step S12, is directly subjected to treatments in step S2 and subsequent steps, and the DMSO in step S2 is replaced with GBL. In other words, in contrast to Embodiment 1, the treatments in steps S13 and S14 are omitted, and the DMSO in step S2 is replaced with GBL.

### Comparative Embodiment 5

This comparative embodiment provides a method for recovering lead iodide from a perovskite solar battery. The method for recovering lead iodide from a perovskite solar battery in this comparative embodiment differs from the method in Embodiment 1 in that the solar battery, which exposes the transport layer and is obtained in step S12, is directly subjected to treatments in step S2 and subsequent steps, and the DMSO in step S2 is replaced with NMP. In other words, in contrast to Embodiment 1, the treatments in steps S13 and S14 are omitted, and the DMSO in step S2 is replaced with NMP.

The lead iodide recovered by the method for recovering lead iodide from a perovskite solar battery in all the above embodiments and comparative embodiments is tested to check the performance metrics such as purity. The test results are shown in Table 1 below:

**Table 1**

| | Purity of lead iodide (cations) (mol%); | Thermal weight loss (high-boiling solvent residue, wt%) | Relative recovery rate (recovery rate in embodiment/comparative embodiment vs Embodiment 1) |
|---|---|---|---|
| Embodiment 1 | 99.7% | 0.2% | 100% |
| Embodiment 2 | 99.5% | 0.3% | 98% |
| Embodiment 3 | 99.6% | 0.1% | 99% |
| Embodiment 4 | 99.1% | 0.7% | 99% |
| Embodiment 5 | 99.2% | 0.5% | 96% |
| Embodiment 6 | 99.6% | 0.3% | 99% |
| Embodiment 7 | 99.3% | 0.5% | 99% |
| Embodiment 8 | 99.4% | 0.4% | 99% |
| Comparative Embodiment 1 | 98.3% | 9% | 110% |
| Comparative Embodiment 2 | 98.8% | 8% | 109% |
| Comparative Embodiment 3 | 97.6% | 3% | 102% |
| Comparative Embodiment 4 | 95.6% | 6% | 105% |
| Comparative Embodiment 5 | 96.2% | 5% | 104% |

As can be seen from the test data in Table 1, in the method for recovering lead iodide from a perovskite solar battery in an embodiment of this application, a relatively low-boiling solvent is used as a counter-solvent, and a precipitation method is applied to directly precipitate lead iodide from a lead iodide-containing solution to separate the lead iodide from the corresponding solvent, thereby significantly reducing the amount of residues of high-boiling solvents in the recovered lead iodide, significantly improving the purity of the recovered lead iodide, avoiding distillation, and reducing energy consumption. Specifically, as shown in Embodiments 1 to 8 in Table 1, the actual recovery rate is up to 99.1 mol% or above, and the thermal weight loss rate is lower than 0.7 wt%. The purity of the recovered lead iodide is significantly higher than that in Comparative Embodiments 1 to 5. In Comparative Embodiments 1 to 5, the lead iodide is recovered by using a conventional distillation and drying process, thereby resulting in a large amount of residues of high-boiling solvents, a high thermal weight loss rate, and high energy consumption.

Further, regarding Embodiment 4 versus other embodiments, in Embodiment 4, the lead iodide is precipitated by using low-boiling solvents, and then dried directly, resulting in a thermal weight loss rate higher than that in Embodiments 1 to 3 and Embodiments 5 to 8 but still significantly lower than that in the comparative embodiments. Therefore, the method of for recovering lead iodide from a perovskite solar battery in an embodiment of this application can further improve the purity of the lead iodide by cleaning the perovskite layer recovered from the recycled perovskite solar cells and by further purifying the lead iodide precipitate. In addition, the solvent is fractionated while collecting the lead iodide precipitate, so as to obtain a high-boiling solvent and a low-boiling solvent separately, and the solvent recovered by fractionation is recycled, thereby effectively reducing the total amount of solvent used in the method for recovering lead iodide from a perovskite solar battery in an embodiment of this application, and in turn, further reducing the cost of recovering lead iodide, reducing the emissions of the waste liquid, and improving the environment-friendliness.

Finally, it is hereby noted that the foregoing embodiments are merely intended to describe the technical solutions of this application but not to limit this application. Although this application has been described in detail with reference to the foregoing embodiments, a person of ordinary skill in the art understands that modifications may still be made to the technical solutions described in the foregoing embodiments, or equivalent replacements may still be made to some or all technical features in the technical solutions. Such modifications and equivalent replacements fall within the scope of the claims and specification hereof without making the essence of the corresponding technical solutions depart from the scope of the technical solutions of the embodiments of this application. Particularly, to the extent that no structural conflict exists, various technical features mentioned in different embodiments may be combined in any manner. This application is not limited to the specific embodiments disclosed herein, but includes all technical solutions falling within the scope of the claims.

## Claims

1. A method for recovering lead iodide from a perovskite solar battery, **characterized in that** the method comprises the following steps:
pretreating a recycled perovskite solar battery to obtain perovskite;
putting the perovskite into a second solvent to dissolve lead iodide to obtain a lead iodide-containing solution; and
mixing the lead iodide-containing solution with a third solvent to precipitate the lead iodide, and collecting a lead iodide precipitate, wherein a boiling point of the third solvent is lower than a boiling point of the second solvent.

2. The method according to claim 1, **characterized in that** the second solvent comprises a complexing solvent; and/or
the third solvent comprises at least one of alcohol, ketone, ether, ester, or aromatic hydrocarbon; and/or
the perovskite comprises a plurality of sheets, and the plurality of sheets of perovskite are placed together in the second solvent to dissolve the lead iodide; and/or
the step of dissolving the lead iodide is accompanied by ultrasonication.

3. The method according to claim 2, **characterized in that**: the complexing solvent comprises dimethyl sulfoxide or a mixed solvent formed by mixing dimethyl sulfoxide with at least one of N,N-dimethylformamide, N-methyl-pyrrolidone, or γ-butyrolactone.

4. The method according to claim 2, **characterized in that** the alcohol comprises at least one of ethanol, methanol, propanol, or butanol;
the ketone comprises at least one of acetone or butanone;
the ether comprises at least one of methyl ether, methyl ethyl ether, ethyl ether, or petroleum ether;
the ester comprises at least one of methyl formate, ethyl formate, methyl acetate, or ethyl acetate; and
the aromatic hydrocarbon comprises at least one of hexane, pentane, or heptane.

5. The method according to any one of claims 1 to 4, **characterized in that** steps of pretreating a recycled perovskite solar battery comprise:
removing a glass layer and an electrode layer from the perovskite solar battery to obtain a solar battery that exposes a transport layer;
putting the solar battery with the exposed transport layer into a transport layer dissolvent to dissolve the transport layer, and then cleaning the solar battery by using a first solvent, and drying the cleaned product to obtain perovskite, wherein a boiling point of the first solvent is lower than the boiling point of the second solvent;
and/or
after the step of collecting a lead iodide precipitate, the method further comprises a step of purifying the collected lead iodide precipitate:
washing the lead iodide precipitate for at least one time by using a fourth solvent, wherein a boiling point of the fourth solvent is lower than the boiling point of the second solvent.

6. The method according to claim 5, **characterized in that** the first solvent and the fourth solvent each independently comprise at least one of alcohol, ketone, ether, ester, or aromatic hydrocarbon.

7. The method according to claim 6, **characterized in that** the alcohol comprises at least one of ethanol, methanol, propanol, or butanol;
the ketone comprises at least one of acetone or butanone;
the ether comprises at least one of methyl ether, methyl ethyl ether, ethyl ether, or petroleum ether;
the ester comprises at least one of methyl formate, ethyl formate, methyl acetate, or ethyl acetate; and
the aromatic hydrocarbon comprises at least one of hexane, pentane, or heptane.

8. The method according to claim 5, **characterized in that** the first solvent, the third solvent, and the fourth solvent each independently are at least one of ethanol, methanol, propanol, or butanol; and
the second solvent is dimethyl sulfoxide.

9. The method according to claim 5, **characterized in that** the step of dissolving the transport layer and/or the step of cleaning by using a first solvent is accompanied by ultrasonication.

10. The method according to claim 5, **characterized in that** the transport layer dissolvent comprises at least one of chlorobenzene, methylbenzene, dichlorobenzene, ethyl acetate, or dimethylbenzene.

11. The method according to any one of claims 1 to 10, **characterized in that**, when collecting the lead iodide precipitate, the method further comprises the following recycling step for a mixed filtrate containing the second solvent and the third solvent:
fractionating the mixed filtrate to obtain a recovered second solvent and a recovered third solvent separately; and
introducing the recovered second solvent into the process of lead iodide dissolution, and introducing the recovered third solvent into the process of mixing the lead iodide-containing solution with the third solvent.

12. The method according to any one of claims 1 to 10, **characterized in that** the lead iodide at least exhibits any one of the following characteristics:
a crystallographic orientation of the lead iodide is (0 0 1);
a purity of the lead iodide is 99.1 mol% or higher;
a thermal weight loss of the lead iodide is less than 0.7 wt%; or
a solubility of the lead iodide in a DMF solvent is 0.5 g/ml.

13. A recycling system for recovering lead iodide from a perovskite solar battery, **characterized in that** the system is configured to implement the method according to any one of claims 1 to 12, and the system comprises:
a recycled perovskite solar battery stripping apparatus, configured to strip the recycled perovskite solar battery to recover perovskite;
a lead iodide extraction apparatus, configured to extract lead iodide from the perovskite; and
a lead iodide precipitate separation apparatus, configured to perform precipitation on the lead iodide-containing solution obtained through treatment by the lead iodide extraction apparatus, so as to obtain the lead iodide precipitate.

14. The recycling system according to claim 13, **characterized in that**: the recycled perovskite solar battery stripping apparatus comprises a glass substrate stripping apparatus, an electrode separation apparatus, a transport layer dissolution apparatus, and a perovskite cleaning apparatus; and the glass substrate stripping apparatus, the electrode separation apparatus, the transport layer dissolution apparatus, and the perovskite cleaning apparatus are connected sequentially in such order that the recycled perovskite solar battery undergoes the following processes sequentially: glass substrate stripping, electrode separation, transport layer dissolution, and perovskite cleaning, wherein the perovskite cleaning apparatus is connected to the lead iodide extraction apparatus.

15. The recycling system according to claim 13, **characterized in that**
the lead iodide extraction apparatus comprises at least a lead iodide dissolution vessel and a first solid-liquid separation component; and, in the lead iodide extraction apparatus, the lead iodide dissolution vessel and the first solid-liquid separation component are connected sequentially in such order that the lead iodide dissolution occurs before the solid-liquid separation; and
the lead iodide precipitate separation apparatus comprises at least a lead iodide precipitation vessel and a second solid-liquid separation component; and, in the lead iodide precipitate separation apparatus, the lead iodide precipitation vessel and the second solid-liquid separation component are connected sequentially in such order that the lead iodide precipitation occurs before the solid-liquid separation, wherein the lead iodide precipitation vessel is connected to a solution outlet of the first solid-liquid separation component.

16. The recycling system according to claim 15, **characterized in that**: the lead iodide precipitate separation apparatus further comprises a fractionation component, the fractionation component is connected to a solution outlet of the second solid-liquid separation component, the fractionation component comprises at least a second solvent outlet and a third solvent outlet, the second solvent outlet is connected to the lead iodide dissolution vessel, and the third solvent outlet is connected to the lead iodide precipitation vessel.

17. The recycling system according to any one of claims 14 to 16, **characterized in that** the system further comprises a lead iodide purification apparatus, and the lead iodide purification apparatus is connected to the lead iodide precipitate separation apparatus.
